# EUROPEAN PATENT APPLICATION

(11) **EP 2 282 330 A2**
(43) Date of publication of application: **09.02.2011**
(21) Application number: 10171425.1
(22) Date of filing: 30.07.2010
(51) Int. Cl.: H01L 21/677

(54) **Transfer device and processing system having the same**

(30) Priority: 31.07.2009 JP 2009178870
(71) Applicant: Tokyo Electron Limited, Tokyo 107-6325 (JP)
(72) Inventor: Yamada, Youhei, Yamanashi 407-8511 (JP)
(74) Representative: HOFFMANN EITLE

(57) **Abstract**

A transfer device includes a base; and a substrate supporter for supporting one or more target substrates to be processed. The substrate supporter is forwardly and backwardly moved to transfer the target substrates. The transfer device further includes reflecting bodies provided at least above and below the substrate supporter, the reflecting bodies serving to reflect heats radiated from the target substrates supported by the substrate supporter.

## Description

### Field of the Invention

The present invention relates to a transfer device for transferring a target substrate to be processed, e.g., a large-scale substrate used for a solar battery; and a processing system having the same, for performing a process on the target substrate.

### Background of the Invention

For the manufacturing process of a solar battery, a flat panel display (FPD) such as a liquid crystal display (LCD), or the like, there has been disclosed a single sheet multi chamber type processing system including a processing chamber in which a predetermined process such as an etching process or a film-forming process is carried out on a large scale glass substrate; and a preheating chamber in which the substrate is preheated to a process temperature (see, e.g., Japanese Patent Application Publication No. H10-098085).

Such a processing system includes a common transfer chamber having a transfer device for transferring a large scale substrate (target substrate to be processed); a load-lock chamber in which a processed substrate is exchanged with a target substrate to be processed; and the aforementioned preheating chamber and the aforementioned processing chamber. The load-lock chamber, the preheating chamber and the processing chamber are arranged around the common transfer chamber. By the transfer device provided in the common transfer chamber, the target substrate is transferred from the load-lock chamber to the preheating chamber, from the preheating chamber to the processing chamber, and from the processing chamber to the load-lock chamber.

A processing time can be reduced in the case of preheating a substrate to the process temperature in the preheating chamber before a predetermined process is carried out as compared with the case of heating the substrate to the process temperature in the processing chamber. However, while the substrate is transferred from the preheating chamber to the processing chamber, the temperature of the substrate is decreased. Accordingly, the substrate is required to be re-heated in the processing chamber for a specific period of time.

Further, in a batch type processing system that processes a plurality of substrates at a time, it is difficult to control the temperature of each of the substrates with high accuracy because the temperature difference between an uppermost substrate or a lowermost substrate and a substrate intermediately provided therebetween is increased.

### Summary of the Invention

In view of the above, the present invention provides a transfer device and a processing system using the same, capable of reducing a time required to re-heat a target substrate to be processed in a processing chamber while controlling the temperature of each of a plurality of substrates with high accuracy even when the substrates are transferred at a time.

In accordance with a first aspect of the present invention, there is provided a transfer device including: a base; a substrate supporter for supporting one or more target substrates to be processed, the substrate supporter being forwardly and backwardly moved to transfer the target substrates; and reflecting bodies provided at least above and below the substrate supporter, the reflecting bodies serving to reflect heats radiated from the target substrates supported by the substrate supporter.

In accordance with a second aspect of the present invention, there is provided a processing system including: a common transfer chamber; a preheating chamber, connected to the common transfer chamber, for preheating one or more target substrates to be processed; a load-lock chamber, connected to the common transfer chamber, for switching the target substrates; and the transfer device of the first aspect, provided in the common transfer chamber, for transferring the target substrates.

### Brief Description of the Drawings

The objects and features of the present invention will become apparent from the following description of embodiments, given in conjunction with the accompanying drawings, in which:
Fig. 1 is a schematic plan view showing a processing system in accordance with an embodiment of the present invention;
Fig. 2A is a schematic side view showing an example of a transfer device and Fig. 2B is a front view showing the transfer device viewed in a direction of an arrow 2B;
Fig. 3 shows the transfer device where a substrate supporter is moved forwardly and backwardly relative to a base;
Figs. 4A and 4B show how target substrates are transferred;
Fig. 5 shows how heats are radiated from target substrates;
Fig. 6 shows how heats are radiated from target substrates; and
Fig. 7 is a side view showing another example of the transfer device.

### Detailed Description of the Embodiments

An embodiment of the present invention will now be described with reference to the accompanying drawings which form a part hereof.

Further, in the following description and drawings, components having substantially the same configuration and function are denoted by like reference characters.

Taken for an example of a target substrate to be processed in the present embodiment is a large-scale glass substrate used for manufacturing a solar battery or a flat panel display (FPD) and a processing system that performs a predetermined process, e.g., an etching process or a film-forming process, on the large scale glass substrate is exemplified.

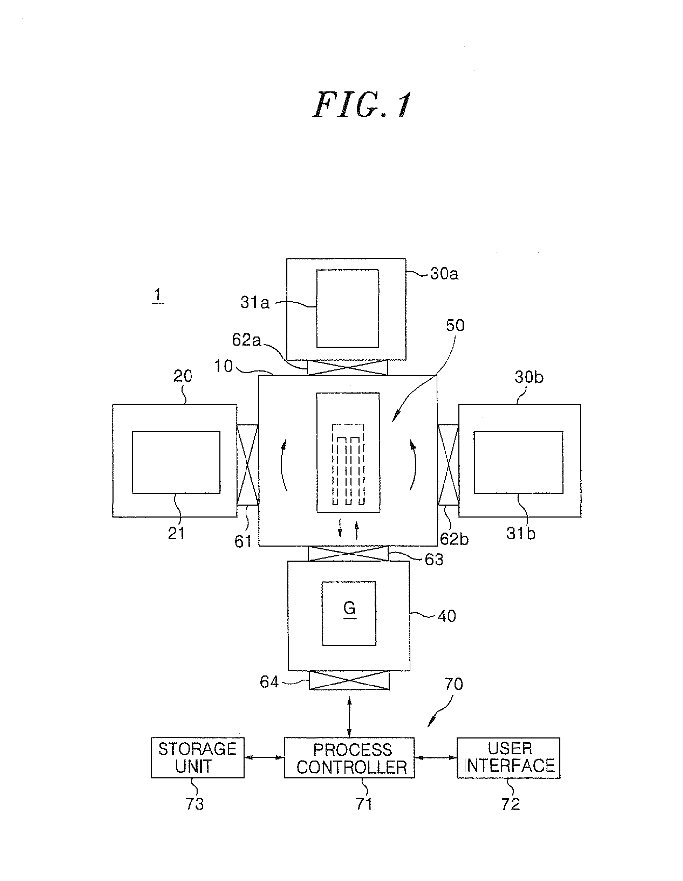

Fig. 1 is a schematic plan view showing a processing system 1 in accordance with an embodiment of the present invention.

As shown in Fig. 1, the processing system 1 of the present embodiment includes a common transfer chamber 10; a preheating chamber 20 for preheating a target substrate G to be processed; processing chambers 30a and 30b for performing an etching process, a film-forming process, or the like on the target substrate G; a load-lock chamber 40 for switching the target substrate G between a substrate container (not shown) disposed in an atmosphere and the common transfer chamber 10 that is maintained in a vacuum state; and a transfer device 50 provided in the common transfer chamber 10 to transfer the target substrate G. The preheating chamber 20, the processing chambers 30a and 30b, and the load-lock chamber 40 are arranged around the common transfer chamber 10.

The common transfer chamber 10 is formed in a rectangular shape seen from the top. The preheating chamber 20, the processing chambers 30a and 30b, the load-lock chamber 40 are connected to side surfaces of the common transfer chamber 10 through gate valves 61, 62a, 62b, and 63, respectively. In addition, a gate valve 64 is provided on the atmospheric side of the load-lock chamber 40. Although the common transfer chamber 10 of the present embodiment has the rectangular shape seen from the top as described above, the common transfer chamber 10 may have a polygonal (e.g., hexagonal or octagonal) shape, and the preheating chamber, the processing chamber, and the load-lock chamber may additionally be provided.

In the present embodiment, the common transfer chamber 10, the preheating chamber 20 and the processing chambers 30a and 30b are respectively configured as vacuum chambers and maintained in a predetermined depressurized state. The preheating chamber 20 and the processing chambers 30a and 30b include therein respective mounting tables 21, 31a, and 31b, each for mounting thereon the target substrate G. Furthermore, the load-lock chamber 40 is provided to transfer the target substrate G between the substrate container (not shown) disposed in the atmosphere and the common transfer chamber 10 maintained in a vacuum state, the load-lock chamber 40 serving as a vacuum prechamber that can be switched between the atmospheric state and the depressurized state.

The substrate processing system 1 is configured to process at a time a plurality of, e.g., three, target substrates G, each of which is horizontally mounted, the target substrates G being arranged in a vertical direction. The target substrates G are loaded together from the external substrate container into the load-lock chamber 40 through the gate valve 64 by a transfer unit (not shown) in the atmosphere. The loaded substrates G are transferred from the load-lock chamber 40 to the common transfer chamber 10, from the common transfer chamber 10 to the preheating chamber 20, and from the preheating chamber 20 to the processing chambers 30a or 30b through the gate valves 63, 61, and 62a or 62b, respectively.

The target substrates G that have been processed in the processing chamber 30a or 30b are transferred from the processing chamber 30a or 30b to the common transfer chamber 10 and from the common transfer chamber 10 to the load-lock chamber 40 through the gate valve 62a or 62b and 63, respectively. Then, the processed substrates G are unloaded from the load-lock chamber 40. Although the processing chambers 30a and 30b perform the same process in the present embodiment, the processing chambers 30a and 30b may be configured to perform different processes. In other words, a first process may be carried out in the processing chamber 30a and, successively, a second process may be performed in the processing chamber 30b.

The transfer device 50 serves to transfer the target substrates G between the common transfer chamber 10, the preheating chamber 20, the processing chambers 30a and 30b, and the load-lock chamber 40. To that end, the transfer device 50 is configured to move upwardly, downwardly and rotationally, and forwardly and backwardly between the common transfer chamber 10, the preheating chamber 20, the processing chambers 30a and 30b, and the load-lock chamber 40.

The respective components of the processing system 1 are controlled by a control unit (computer) 70. The control unit 70 includes a process controller 71 having a micro processor. The process controller 71 is connected to a user interface 72 including a keyboard through which an operator inputs a command or the like to manage the processing system 1, a display unit for visually displaying an operation status of the processing system 1, and the like. Further, the process controller 71 is connected to a storage unit 73 which stores therein control programs for realizing various processes performed by the processing system 1 under the control of the process controller 71; and control programs or recipes for performing predetermined processes performed by the processing system 1 under processing conditions. The storage unit 73 has a storage medium which stores therein the recipes or the like.

The storage medium may be a hard disk, a semiconductor memory or a portable storage medium such as a CD-ROM, a DVD, a flash memory or the like. If necessary, a certain recipe is retrieved from the storage unit 73 in response to an instruction from the user interface 72 or the like and is executed by the process controller 71, thereby performing a desired process in the processing system 1 under the control of the process controller 71.

Next, an example of the processing operation of the processing system 1 will be described.

First, the gate valve 64 is opened and a plurality of, e.g., three, target substrates G to be processed are loaded into the load-lock chamber 40 maintained in an atmospheric state by the substrate transfer device (not shown) disposed in the atmosphere. Then, the gate valve 64 is closed, and the inside of the load-lock chamber 40 is set to a depressurized state. Next, the gate valve 63 is opened, and the transfer device 50 is moved forwardly into the load-lock chamber 40 to take the target substrates G loaded to the load-lock chamber 40. Then, the transfer device 50 returns to the common transfer chamber 10, and the gate valve 63 is closed.

Next, the transfer device 50 is rotated so as to face the preheating chamber 20. Then, the gate valve 61 is opened, and the transfer device 50 is moved forwardly into the preheating chamber 20 to transfer the target substrates G to the preheating chamber 20. Then, the transfer device 50 returns to the common transfer chamber 10, and the gate valve 61 is closed. Thereafter, the target substrates G are started to be preheated in the preheating chamber 20. If the preheating is completed, the gate valve 61 is opened; and the transfer device 50 is moved forwardly into the preheating chamber 20 to take the preheated target substrates G. Then, the transfer device 50 returns to the common transfer chamber 10, and the gate valve 61 is closed.

Next, the transfer device 50 is rotated so as to face the processing chamber 30a or 30b. Then, the gate valve 62a or 62b is opened, and the transfer device 50 is moved forwardly into the processing chamber 30a or 30b to transfer the preheated target substrates G to the processing chamber 30a or 30b. Then, the transfer device 50 returns to the common transfer chamber 10, and the gate valve 62a or 62b is closed. Thereafter, the target substrates G are started to be processed in the processing chamber 30a or 30b. If the process is completed, the gate valve 62a or 62b is opened; and the transfer device 50 is moved forwardly into the processing chamber 30a or 30b to take the processed substrates G. Then, the transfer device 50 returns to the common transfer chamber 10, and the gate valve 62a or 62b is closed.

Next, the transfer device 50 is rotated so as to face the load-lock chamber 40. Then, the gate valve 63 is opened, and the transfer device 50 is moved forwardly into the load-lock chamber 40 to transfer the processed substrates G to the load-lock chamber 40. Then, the transfer device 50 returns to the common transfer chamber 10, and the gate valve 63 is closed. Thereafter, the inside of the load-lock chamber 40 is set to the atmospheric state. Then, the gate valve 64 is opened, and the processed substrates G are unloaded from the load-lock chamber 40 by the substrate transfer device (not shown) in the atmosphere.

Next, the transfer device 50 will be described.

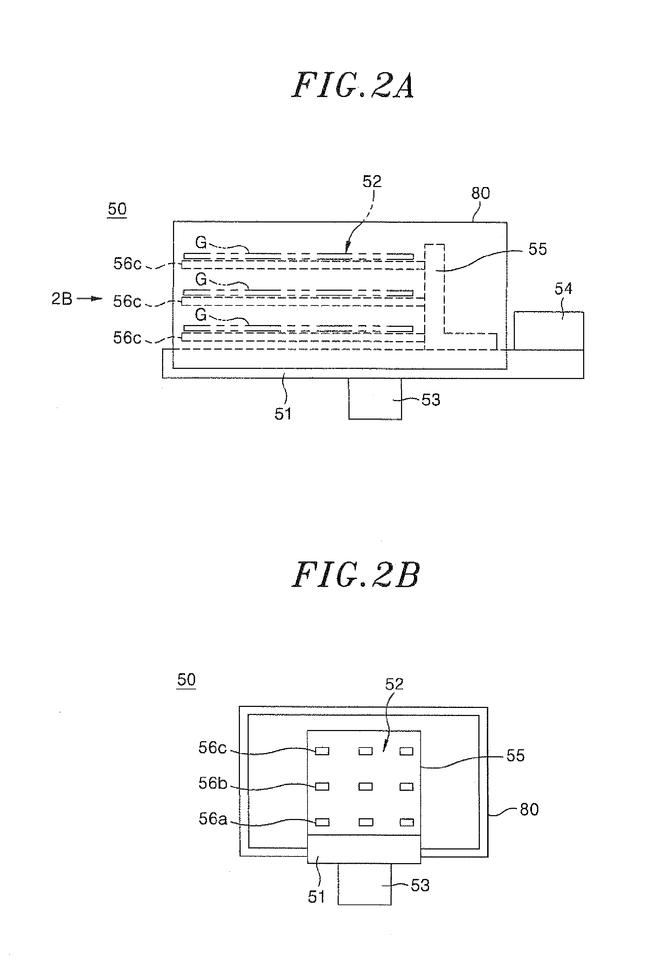

Fig. 2A is a schematic side view showing an example of the transfer device 50 and Fig. 2B is a front view showing the transfer device 50 viewed in the direction of an arrow 2B.

As shown in Figs. 2A and 2B, the transfer device 50 basically includes a horizontal base 51; and a substrate supporter 52 for supporting one or more target substrates G to be processed, the substrate supporter 52 being forwardly and backwardly moved relative to the horizontal base 51 to transfer the target substrates G.

The transfer device 50 further includes an elevation/rotation unit 53 for elevating and rotating the horizontal base 51; and a reciprocating unit 54 for forwardly and backwardly reciprocating the substrate supporter 52. The transfer device 50 itself is upwardly and downwardly moved and rotated by upwardly and downwardly moving and rotating the horizontal base 51 by the elevation/rotation unit 53.

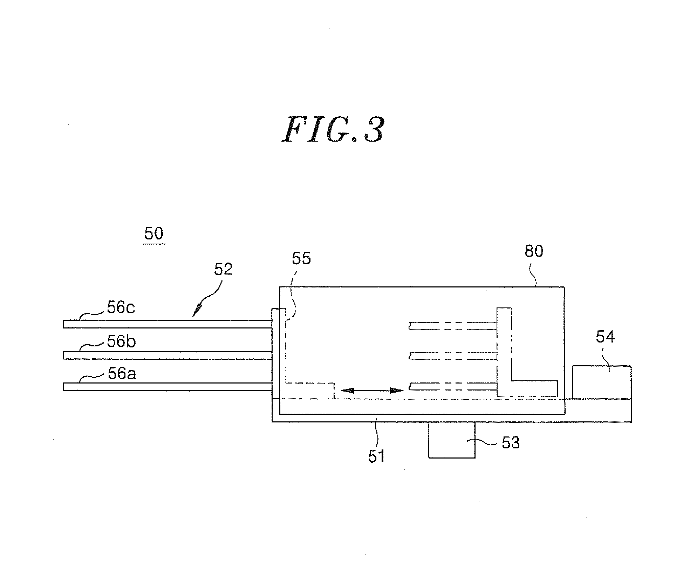

The substrate supporter 52 includes a vertical base 55 and a plurality of supporting members 56 (e.g., three supporting members 56a, 56b and 56c in Figs. 2A and 2B) horizontally extending from the vertical base 55. The vertical base 55 is configured to slide on the horizontal base 51. As shown in Fig. 3, the substrate supporter 52 is forwardly and backwardly moved relative to the horizontal base 51 by forwardly and backwardly moving the vertical base 55 by the reciprocating unit 54.

As described above, the substrate supporter 52 of the present embodiment includes the plurality of supporting members 56 vertically arranged in multiple stages. Accordingly, the substrate supporter 52 can transfer at a time a plurality of target substrates G to be processed. For example, the transfer device 50 including three supporting members 56a, 56b, and 56c can transfer three target substrates G at a time in the present embodiment.

The transfer device 50 further includes reflecting bodies 80 for reflecting heats, especially infrared rays, radiated from the target substrates G supported in the substrate supporter 52.

The reflecting bodies 80 are provided at least above and below the target substrates G supported in the substrate supporter 52 located above the horizontal base 51 such that the target substrates G supported by the substrate supporter 52 are moved between the reflecting bodies 80 while being transferred.

Specifically, in case that the substrate supporter 52 includes the supporting members 56a, 56b, and 56c arranged in multiple stages, as in the present embodiment, the reflecting bodies 80 are provided at least below the lowermost supporting member 56a and above the uppermost supporting member 56c.

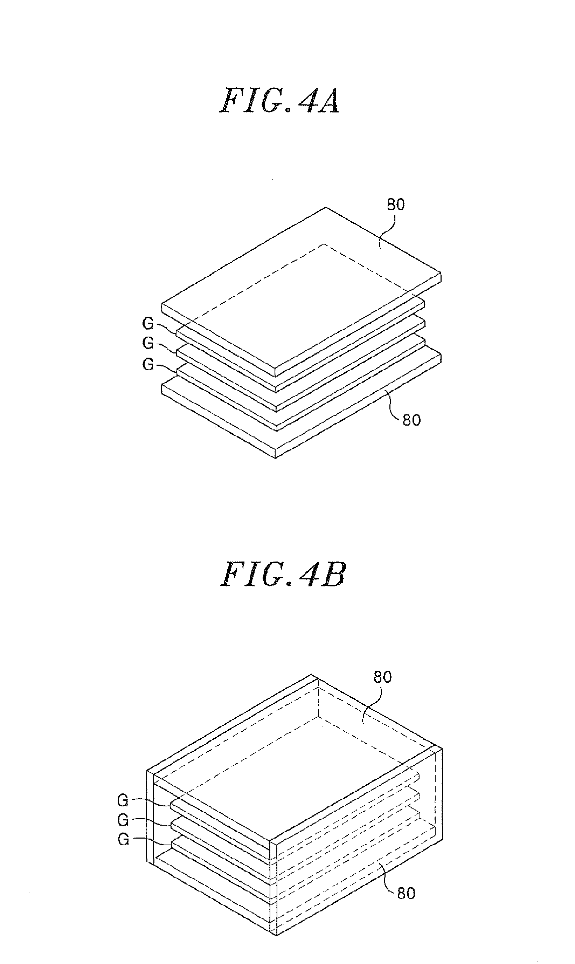

By providing the reflecting bodies 80 as described above, the target substrates G are transferred while being placed between the reflecting bodies 80 as shown in Fig. 4A. While the target substrates G are transferred, heats radiated from the target substrates G are reflected by the reflecting bodies 80 arranged above and below the substrate supporter 52.

Moreover, the reflecting bodies 80 may be provided at sides of the substrate supporter 52 as well as above and below the substrate supporter 52. Accordingly, the reflecting bodies 80 may be arranged to have a tubular shape, and the target substrates G are transferred while being surrounded by the reflecting bodies 80.

The heats radiated from the target substrates G supported by the substrate supporter 52 are reflected by the reflecting bodies 80. To that end, a surface of each of the reflection bodies 80 which faces the target substrates G is required to serve as a heat-reflecting surface capable of reflecting at least heat. In the present embodiment, the inner surfaces of the reflecting bodies 80 arranged to have the tubular shape serve as the heat-reflecting surface. It is preferable that the heat-reflecting surface is made of a material, e.g., aluminum, capable of easily reflecting infrared rays, and that it is a mirror surface or a polished surface made by polishing a metal material.

As such, the transfer device 50 of the processing system 1 in accordance with the present embodiment may include the reflecting bodies 80 for reflecting heats radiated from the target substrates G and transfer the target substrates G while the target substrates G are placed between or surrounded by the reflecting bodies 80. In the depressurized atmosphere, the heated target substrates G are cooled a little by a gas serving as a heat-transfer medium or the convection of a gas whereas they are significantly cooled by the discharge of the heats radiated from the target substrates G. For that reason, as compared with a transfer device having no reflecting body 80, it is possible to significantly suppress the decrease in temperature of the target substrates G while they are transferred, for example, from the preheating chamber 20 to the processing chamber 30a or 30b. Accordingly, by using the transfer device 50 having the reflecting bodies 80, it is possible to reduce a time required to re-heat the target substrates G in the processing chamber 30a or 30b.

As described above, it is sufficient to provide the reflecting bodies 80 above and below the substrate supporter 52. However, in case that the reflecting bodies 80 are arranged to have a tubular shape such that the substrate supporter 52 is surrounded by the reflecting bodies 80 when the substrate supporter 52 is placed above the horizontal base 51, it is possible to more efficiently suppress the decrease in temperature of the target substrates G while the target substrates G are transferred.

Moreover, the following benefits can be obtained by the transfer device 50 included in the processing system 1 of the present embodiment.

For example, when the transfer device 50 transfers a plurality of, e.g., three or more, target substrates G, the temperature difference between an uppermost or a lowermost target substrate G and an intermediate target substrate G provided therebetween may be increased.

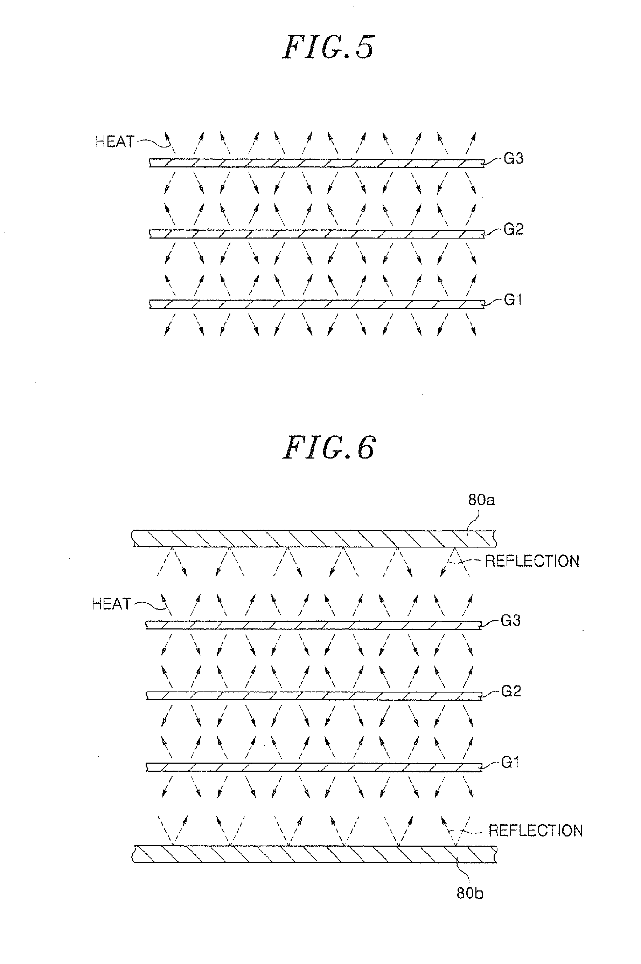

As shown in Fig. 5, while the intermediate target substrate G2 radiates a heat, it receives heats radiated from the target substrates G1 and G3 respectively provided below and above the target substrate G2, thereby suppressing the decrease in temperature thereof. Since, however, the lowermost or the uppermost target substrate G1 or G3 has only one adjacent target substrate provided thereabove or therebelow, the temperature of the target substrate G1 or G3 may easily be reduced as compared with the intermediate target substrate G2. Accordingly, when three or more target substrates G are transferred, the temperature difference between the uppermost and the lowermost target substrate G and the intermediate target substrate G may be increased.

On the other hand, in the transfer device 50 of the processing system 1 in accordance with the present embodiment, reflecting bodies 80a and 80b are respectively provided above the uppermost target substrate G3 and below the lowermost target substrate G1 as shown in Fig. 6. Accordingly, even when three or more target substrates G are transferred, it is possible to suppress the increase in temperature difference between the uppermost or the lowermost target substrate G and the intermediate target substrate G, thereby controlling the temperature of each of the target substrates with high accuracy.

Although the embodiment of the present invention has been described above, the present invention is limited to the embodiment, and various modifications may be made. In other words, the present invention may be implemented by other embodiments than the aforementioned embodiment.

For example, although the reflecting bodies 80 are provided at least above and below the substrate supporter 52 in the above-mentioned embodiment, an additional reflecting body for reflecting the heats radiated from the target substrates G may be provided on the surfaces of the supporting members 53 of the substrate supporter 52, for example.

Further, another additional reflecting body may be provided on the surface of the horizontal base 51.

In addition, the reflecting bodies 80 are arranged to have a tubular shape in the aforementioned embodiment. However, a box-shaped frame may be attached to the horizontal base 51 and the reflecting bodies may be attached on the box-shaped frame.

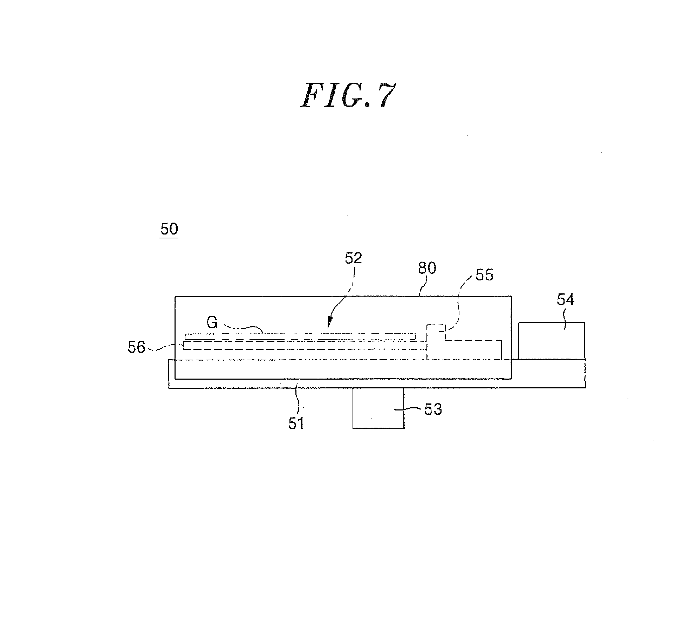

Further, the processing system 1 of the aforementioned embodiment transfers and processes three target substrates G at a time. The present invention, however, is not limited thereto. For example, as shown in Fig. 7, the transfer device 50 may have a single supporting member to transfer one target substrate G. Alternatively, the transfer device 50 may have two or four or more supporting member to transfer two or four or more, target substrates G.

Moreover, in the above-mentioned embodiment, the substrate supporter 52 includes the supporting members 56 horizontally extending from the vertical base 55 that slides on the horizontal base 51. However, the substrate supporter 52 is not limited thereto. The substrate supporter 52 may have any other configurations for transferring the target substrates G. For example, the supporting member 56 may further slide thereon e. Further, the present invention is not limited to the transfer type in which the vertical base 55 slides on the horizontal base 51. The present invention may use a SCARA transfer type having joints.

Finally, a glass substrate for manufacturing a solar battery or an FPD is used as a target substrate to be processed. The target substrate is not limited to the glass substrate. A semiconductor wafer or the like may be used.

In accordance with the embodiments of the present invention, the transfer device and the processing system using the same are capable of reducing a time required to re-heat a target substrate to be processed in the processing chamber and controlling the temperature of each of a plurality of substrates with high accuracy even when the substrates are transferred at a time.

While the invention has been shown and described with respect to the embodiments, it will be understood by those skilled in the art that various changes and modifications may be made without departing from the scope of the invention as defined in the following claims.

## Claims

1. A transfer device comprising:
a base;
a substrate supporter for supporting one or more target substrates to be processed, the substrate supporter being forwardly and backwardly moved to transfer the target substrates; and
reflecting bodies provided at least above and below the substrate supporter, the reflecting bodies serving to reflect heats radiated from the target substrates supported by the substrate supporter.

2. The transfer device of claim 1, wherein the substrate supporter has a plurality of stages between the reflecting bodies.

3. The transfer device of claim 1 or 2, wherein the reflecting bodies are arranged to have a tubular shape such that the substrate supporter is surrounded by the reflecting bodies.

4. The transfer device of any one of claims 1 to 3, wherein at least a surface of each of the reflecting bodies which faces the target substrate serves as a heat-reflecting surface for reflecting a heat.

5. The transfer device of any one of claims 1 to 4, further comprising another reflecting body provided on a surface of the substrate support to reflect the heat radiated from the target substrate.

6. The transfer device of any one of claims 1 to 5, further comprising another reflecting body provided on a surface of the base to reflect the heat radiated from the target substrate.

7. A processing system comprising:
a common transfer chamber;
a preheating chamber, connected to the common transfer chamber, for preheating one or more target substrates to be processed;
a processing chamber, connected to the common transfer chamber, for processing the target substrates;
a load-lock chamber, connected to the common transfer chamber, for switching the target substrates; and
the transfer device of any one of claims 1 to 6, provided in the common transfer chamber, for transferring the target substrates,
